# EUROPÄISCHE PATENTSCHRIFT

(11) **EP 0 450 486 B1**
(45) Veröffentlichungstag und Bekanntmachung des Hinweises auf die Patenterteilung: **16.10.1996**
(21) Anmeldenummer: 91104866.8
(22) Anmeldetag: 27.03.1991
(51) Int. Cl.: G03F 7/38, G03F 7/20

(54) **Nachbehandlungsgerät für Druckplatten**
Post treatment apparatus for printing plates
Appareil pour le post-traitement des plaques d'impression

(30) Priorität: 05.04.1990 DE 4011023
(43) Veröffentlichungstag der Anmeldung: 09.10.1991
(73) Patentinhaber: Agfa-Gevaert AG, D-51373 Leverkusen (DE)
(72) Erfinder: Zertani, Rudolf, Dr. Dipl.-Chemiker, W-6500 Mainz 43 (DE); Lüllau, Rudolf, Dipl.-Ing., W-2120 Lüneburg (DE); Lüllau, Friedrich, Dipl.-Ing., W-2123 Bardowick (DE)

(56) Entgegenhaltungen:
- DE-A- 2 706 913
- DE-U- 8 810 445
- US-A- 3 958 586
- PATENT ABSTRACTS OF JAPAN, vol. 7, no. 188 (P-217)(1333) 17. August 1983 & JP-A-58 087 556

## Beschreibung

Die Erfindung betrifft ein Nachbehandlungsgerät für Druckplatten, die bildmäßig belichtet sind, mit einer Wärmestation.

Aus der DE-B-12 14 085 (US-A-3,144,331) ist es bekannt, zur Wiederherstellung der Empfindlichkeit fotopolymerisierbare Aufzeichnungsmaterialien, die als lichtempfindliche Schicht auf einem Druckplattenträger aufgetragen sind und deren Empfindlichkeit durch Absorption von molekularem Sauerstoff nachgelassen hat, die lichtempfindliche Schicht mit 70 bis 98 % der Strahlungsmenge einer aktinischen Strahlung zu belichten, die bei gleichmäßigem Auftreffen zur Einleitung einer Fotopolymerisation notwendig wäre. Die Belichtung erfolgt durch den beispielsweise transparenten Druckplattenträger hindurch, wobei eine aktinische Strahlung mit einer solchen Wellenlänge verwendet wird, daß nur 10 bis 70 % der Strahlung von der fotopolymerisierbaren Schicht absorbiert werden. Bei diesem Verfahren wird im Prinzip einmal diffus und einmal bildmäßig belichtet. Die Diffus- bzw. Vorbelichtung erfolgt mit geringerer Intensität, nämlich mit 70 bis 98 % der Strahlungsintensität, die zum Erreichen der vollen Belichtungswirkung erforderlich ist. An diese Vorbelichtung schließt dann die bildmäßige Belichtung mit voller Strahlungsintensität an.

In der US-A-4,298,803 ist ein Verfahren beschrieben, bei dem eine Fotoresistschicht mit einer Intensität vorbelichtet wird, die niedriger als die kritische Belichtungsintensität ist, bei der der Fotoresist an einer bestimmten Stelle vollständig aufgelöst wird. Nach dieser Vorbelichtung erfolgt die bildmäßige Belichtung der Fotoresistschicht. Die Reihenfolge der Vorbelichtung und der bildmäßigen Belichtung kann vertauscht werden. In beiden Fällen wird die Empfindlichkeit der Fotoresistschicht verbessert, wodurch die Bearbeitungszeit stark verkürzt wird. Bei der für dieses Verfahren eingesetzten Vorrichtung können sowohl die bildmäßige Belichtung als auch die Vor-bzw. Nachbelichtung des Fotoresists mittels eines Elektronenstrahls, einer UV- oder Röntgenstrahlenquelle erfolgen.

Aus der US-A-4,716,097 ist gleichfalls ein Verfahren bekannt, bei dem eine fotopolymere Schicht, die einen Farbstoff enthält, zuerst mit Licht einer Wellenlänge oberhalb von 400 nm und einer Intensität von mindestens 1500 Lumen/m² diffus und danach bildmäßig belichtet wird.

In der deutschen Offenlegungsschrift DE-A-24 12 571 ist ein Verfahren zum Aushärten einer durch Licht härtbaren Polymerschicht einer Druckplatte beschrieben, bei dem zuerst diffus für kurze Zeit belichtet und danach bildmäßig so lange belichtet wird, bis die Polymerschicht praktisch vollständig in den belichteten Bereichen ausgehärtet ist. Die diffuse Belichtungsdauer beträgt maximal 90 % der Zeit, innerhalb welcher die vollständige Aushärtung der Polymerschicht bei gleicher Intensität der Strahlung sowohl für die Vorbelichtung als auch für die bildmäßige Belichtung erfolgt.

Aufgabe der Erfindung ist es, ein Nachbehandlungsgerät für Druckplatten, die schon bildmäßig belichtet sind, so weiterzuentwickeln, daß die Bildstellen der Druckplatten zusätzlich gehärtet werden, ohne daß die Nichtbildstellen der Druckplatten anvernetzt werden.

Ein Nachbehandlungsgerät gemäß dem Oberbegriff der Anspruchs 1 ist aus der DE-A-2 706 913 bekannt.

Die Aufgabe wird erfindungsgemäß in der Weise gelöst, daß die Belichtungsstation eine regelbare Strahlungsquelle zur ganzflächigen Belichtung der Druckplatte und eine Filterscheibe aufweist, die an der Unterseite der Belichtungsstation eine Belichtungsöffnung abdeckt, und daß die Wärmestation mit einer IR-Strahlungsquelle in einem an drei Seiten mit einer Isolation versehenen Gehäuse ausgerüstet ist, das nach unten auf einen Reflektortisch hin offen ist, über den die Druckplatte durch das Nachbehandlungsgerät hindurchgeführt ist.

In Ausgestaltung der Erfindung ist die Strahlungsquelle der Belichtungsstation eine Leuchtstofflampe, deren Beleuchtungsstärke zwischen 30 % und 100 % der maximalen Beleuchtungsstärke mittels eines elektronischen Dimmers stufenlos regelbar ist. Dabei liegt der Spektralanteil der Leuchtstofflampe im Wellenlängenbereich von 400 bis 700 nm und haben 80 % der emittierten Strahlung eine Wellenlänge größer als 500 nm.

In weiterer Ausgestaltung der Erfindung ist die Belichtungsöffnung als Spalt ausgebildet, dessen Breite mittels eines Einstellmechanismus von 0,5 bis 20 mm einstellbar ist. Die Filterscheibe, welche die Belichtungsöffnung abdeckt, besteht aus einer Kunststoffscheibe und einer auf diese Kunststoffscheibe aufgeklebten Filterfolie, wobei die Filterfolie für Strahlung oberhalb des Spektralbereichs von 500 nm durchlässig und für Strahlung mit einer Wellenlänge kleiner/gleich 500 nm nahezu undurchlässig ist.

Die weitere Ausgestaltung der Erfindung ergibt sich aus den Merkmalen der Patentansprüche 6 bis 14.

Mit dem Nachbehandlungsgerät nach der Erfindung werden Fotopolymerdruckplatten, insbesondere Projektionsplatten und hoch lichtempfindliche Laserplatten, verarbeitet, wobei durch die Nachbehandlung mit Licht sehr geringer Intensität und die Nacherwärmung die Standzeiten bzw. die Druckauflagenhöhe der so behandelten Druckplatten erheblich gesteigert werden können. Hierzu werden die bildmäßig belichteten Druckplatten, die beispielsweise in einem Laserbelichtungsgerät mit einer Wellenlänge von 488 nm belichtet wurden oder eine Projektionsbelichtung durch einen Quecksilberoder Xenon-Strahler, Blitzlicht, Kohlenstofflampe oder dergleichen erhalten haben, in dem Nachbehandlungsgerät einer zweiten ganzflächigen, diffusen Belichtung mit Licht einer Wellenlänge λ = 450 nm bis 650 nm mit sehr geringer Intensität von ca. 100 bis 800 Lux x Sekunden ausgesetzt und anschließend auf eine Temperatur von 80 °C bis 120 °C in dem gleichen Gerät nacherwärmt. Von Vorteil ist bei diesem Nachbehandlungsgerät, daß sowohl die Belichtungs- als auch die Wärmestation voneinander getrennt regelbar sind.

Die Erfindung wird im folgenden anhand der Zeichnung näher erläutert. Es zeigen:
- Fig. 1: eine schematische Schnittansicht des Nachbehandlungsgeräts gemäß der Erfindung,
- Fig. 2: im Schnitt eine Teilansicht des Reflektortisches des Nachbehandlungsgeräts, und
- Fig. 3: eine Draufsicht auf den Reflektortisch nach Figur 2.

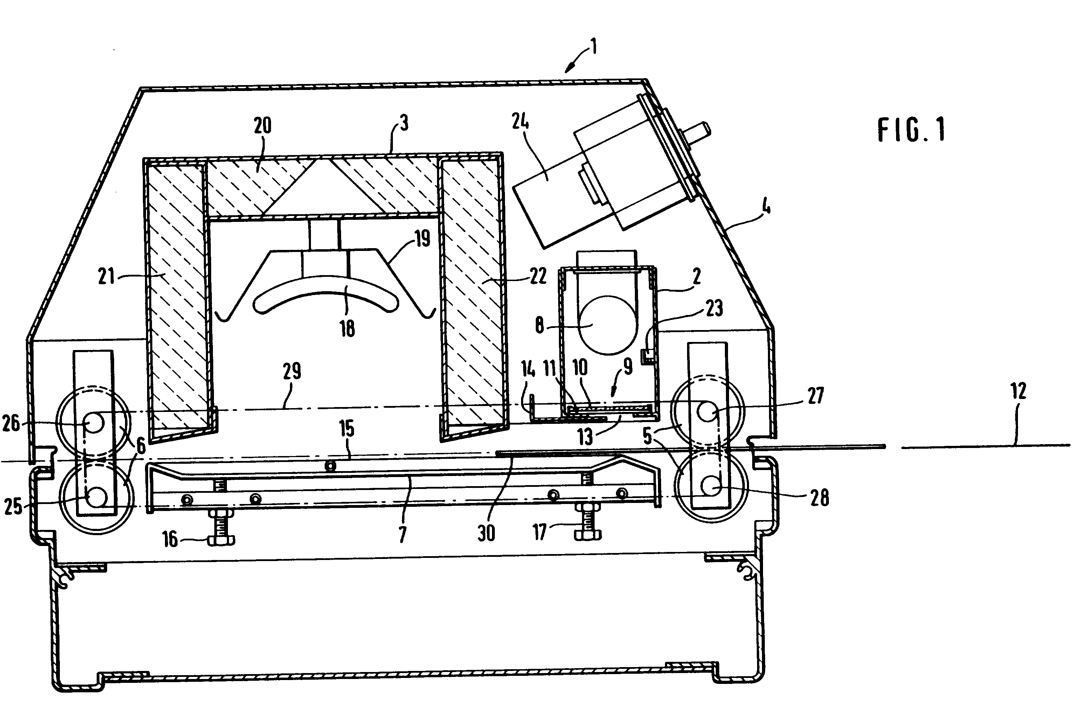

Ein Nachbehandlungsgerät 1 enthält als wesentliche Einheiten eine Belichtungsstation 2, eine Wärmestation 3, einen Reflektortisch 7 und Transportwalzenpaare 5 und 6, wobei diese Einheiten von einem Gehäuse 4 des Nachbehandlungsgeräts umschlossen sind. Druckplatten 30, von denen in Figur 1 eine schematisch dargestellt ist, durchlaufen entlang einer Transportbahn 12 das Nachbehandlungsgerät 1. Für den Transport der Druckplatte 30 durch das Nachbehandlungsgerät sind das Eingangstransportwalzenpaar 5 am Beginn der Transportbahn 12 innerhalb des Geräts und das Ausgangstransportwalzenpaar 6 am Ende der Transportbahn innerhalb des Geräts vorhanden. Auf den Wellen der Transportwalzen dieser beiden Transportwalzenpaare sitzen Stirnzahnräder 25, 26, 27 und 28 auf, über die eine endlos umlaufende Zahnradkette 29 geführt ist. Eine der Transportwalzen des Eingangswalzenpaares 5 wird durch einen nicht gezeigten Elektromotor angetrieben. Das Stirnzahnrad der angetriebenen Transportwalze versetzt die Zahnradkette 29 in Umlauf, wodurch der Synchronlauf zwischen dem Eingangsund dem Ausgangswalzenpaar sichergestellt ist.

Die Belichtungsstation 2 ist der Wärmestation 3, betrachtet in Transportrichtung der Druckplatten, vorgeschaltet. In der Belichtungsstation 2 befindet sich eine regelbare Strahlungsquelle 8 zur ganzflächigen, diffusen Belichtung der Druckplatte 30. Diese Strahlungsquelle 8 ist beispielsweise eine Leuchtstofflampe, die sich in einem geschlossenen Gehäuse der Belichtungsstation 2 befindet. Nach unten hin, in Richtung der Transportbahn 12 für die Druckplatten, weist das Gehäuse der Belichtungsstation 2 eine Belichtungsöffnung 13 auf, die von einer Filterscheibe 9 abgedeckt ist. Die Belichtungsöffnung 13 ist als Belichtungsspalt ausgebildet, dessen Breite durch einen Einstellmechanismus 14 im Bereich von 0,5 bis 20 mm einstellbar ist. Der Einstellmechanismus 14 ist als winkelförmiger Schieber ausgebildet, der in Schienen läuft.

Die Filterscheibe 9 besteht aus einer Kunststoffscheibe 10, beispielsweise aus Polymethylmethacrylat PMMA und einer darauf aufgeklebten Filterfolie 11. Die Filterfolie 11 wird so gewählt, daß sie für Strahlung oberhalb des Spektralbereichs von 500 nm durchlässig und für Strahlung mit einer Wellenlänge kleiner/gleich 500 nm nahezu undurchlässig ist.

Ebenso können Filterscheiben 9 verwendet werden, die Kantenfilter sind und aus einer PMMA-Scheibe allein, die entsprechend gefärbt ist, oder einem speziell eingefärbten Glas, beispielsweise der Fa. Schott, bestehen.

Die Beleuchtungsstärke der Strahlungsquelle 8 der Belichtungsstation 2 ist zur genauen Dosierung der auf die Druckplatte 30 applizierten Lichtmenge elektronisch mit Hilfe eines Dimmers stufenlos zwischen 30 % und 100 % der maximalen Beleuchtungsstärke regelbar. Die Anzeige der Beleuchtungsstärke dieser Strahlungsquelle erfolgt digital, wobei zur Messung der Beleuchtungsstärke ein Sensor 23 im Inneren des Gehäuses der Belichtungsstation 2 angebracht ist. Die Geschlossenheit des Gehäuses verhindert das Auftreten von äußeren Störstrahlungen, die die Messung der Beleuchtungsstärke mittels des Sensors 23 in unerwünschter Weise beeinträchtigen könnten.

Der Dimmer zur Einstellung der Beleuchtungsstärke der Strahlungsquelle 8 ist Teil einer elektronischen Regelung 24, die oberhalb der Belichtungsstation 2 schematisch dargestellt ist.

Der Spektralanteil der Strahlungsquelle 8 liegt im Wellenlängebereich von 400 bis 700 nm, wobei 80 % der emittierten Strahlung eine Wellenlänge größer als 500 nm haben. Der Engergieverlust bzw. die Strahlungsabsorption durch die Filterscheibe 9 bzw. die Filterfolie 11 und somit auch die Erwärmung dieser Bauteile ist durch die gewählte Spektralverteilung der Strahlungsquelle 8 sehr gering.

Der Sensor 23 zur Messung der Beleuchtungsstärke ist üblicherweise ein Fotoelement, das sich im Gehäuse der Belichtungsstation 2 befindet und dadurch von jeglicher Störstrahlung, wie beispielsweise in das Nachbehandlungsgerät 1 einfallendes Tageslicht, abgeschirmt ist.

Die Wärmestation 3 ist mit einer IR-Strahlungsquelle 18 ausgerüstet, die in einem Gehäuse untergebracht ist, das an drei Seiten mit einer Isolation 20, 21, 22 wärmeisoliert ist. Nach unten hin ist das Gehäuse auf den Reflektortisch 7 hin offen, über den die Druckplatte 30 durch das Nachbehandlungsgerät 1 hindurchgeführt wird. Bei der Strahlungsquelle 18 der Wärmestation 3 handelt es sich beispielsweise um einen Infrarot-Dunkelstrahler aus Keramik, der Strahlung in einem Wellenlängenbereich weitab sowohl vom sichtbaren Wellenlängenbereich als auch vom Strahlungsempfindlichkeitsbereich der Druckplatten emittiert. Oberhalb der IR-Strahlungsquelle 18 ist ein Reflektor 19 angebracht. Die von der IR-Strahlungsquelle 18 emittierte Strahlung liegt in einem Wellenlängenbereich von 1000 nm bis über 10000 nm. Durch diesen Spektralbereich der Wärmestrahlung sind voneinander völlig unabhängige Dosierungen der auf die Druckplatten 30 einwirkenden elektromagnetischen Strahlungen möglich, nämlich einerseits die voranstehend erwähnte Infrarotstrahlung zur Erzeugung von Wärme und andererseits die diffuse Belichtung mit sichtbarem Licht zur sogenannten "Nachbelichtung" der schon bildmäßig belichteten Druckplatte.

Die IR-Strahlungsquelle 18 ist in ihrer Strahlungsleistung so regelbar, daß die Druckplatte 30 auf eine Temperatur von 80 °C bis 120 °C erwärmt werden kann.

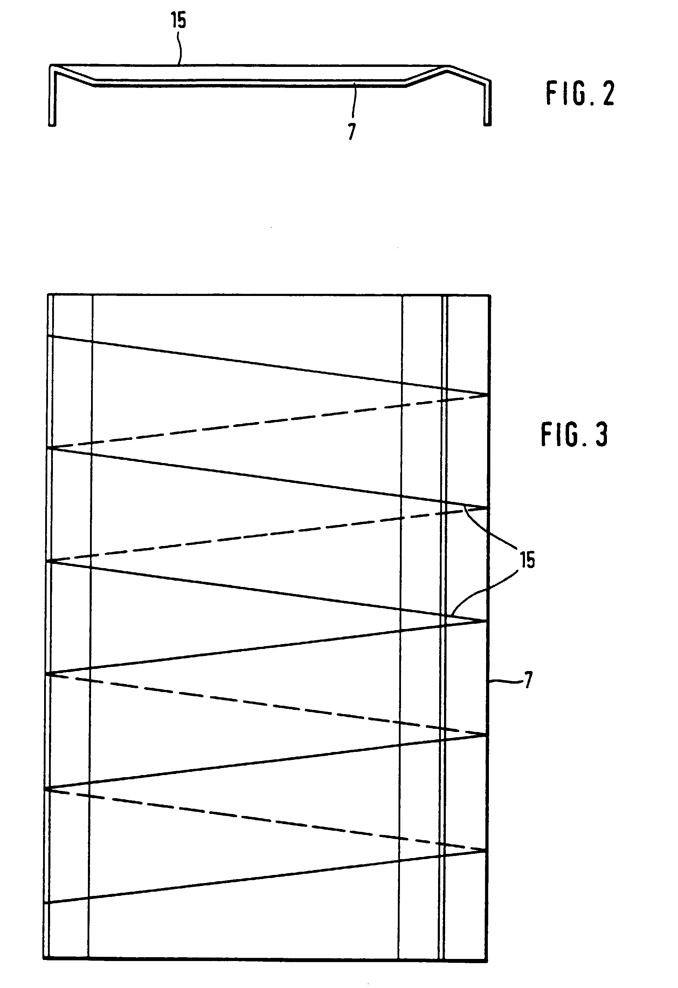

Der Reflektortisch 7 ist als ein trogähnlicher Hohlkörper geformt, der auf der Höhe der Transportbahn 12 der Druckplatten 30 eine Bespannung 15 aufweist, wie aus den Figuren 2 und 3 ersichtlich ist. Die Bespannung 15 besteht entweder aus einem dünnen Metalldraht oder einem dünnen Kunststoffaden und ist auf der Oberseite des Reflektortisches V-förmig aufgespannt (vgl. Fig. 3), damit die vorderen Ecken der Druckplatte beim Transport durch das Nachbehandlungsgerät 1 nicht unterhalb der Bespannung gelangen können, was einen Druckplattenstau zur Folge hätte.

Durch die sehr geringe Wärmekapazität der Bespannung 15 im Vergleich zu der Druckplatte 30 ist gewährleistet, daß an keiner Stelle der Druckplatte während der Erwärmung im Bereich unterhalb der Wärmestation 3 ein Wärmeabfluß entstehen kann, der zu einer ungleichmäßigen Erwärmung der Druckplatte führen könnte. Die Innenseite des Reflektortisches 7 ist mit einem wärmereflektierenden Metallblech ausgekleidet. An der Unterseite des Reflektortisches befinden sich Verstelleinrichtungen 16, 17, üblicherweise Stellschrauben, die ein Anheben und Absenken innerhalb eines kleinen Bereiches der Grundfläche des trogähnlichen Reflektortisches 7 ermöglichen, um so den Abstand der Unterseite der Druckplatte zu der Grundfläche des Reflektortisches in einem bestimmten Maße einstellen zu können.

Ein Wärmeabfluß von der Druckplatte, beispielsweise durch Berührung zwischen der Druckplatte und dem Metallblech des Reflektortisches, könnte zu einer partiellen Temperaturabsenkung im Bereich der Berührungsfläche führen und damit zu einer ungleichmäßigen Erwärmung und somit auch ungleichmäßigen Nachhärtung der Fotopolymerschicht der Druckplatte.

Mit dem Nachbehandlungsgerät werden die Vorteile erzielt, daß die Strahlungsquelle 8 der Belichtungsstation 2 über die Arbeitsbreite der Druckplatte 30 eine sehr gleichmäßige Belichtungsstärke erzeugt, die elektronische Regelung eine hohe Lebensdauer der Strahlungsquelle 8 der Belichtungsstation gewährleistet, die Belichtungsintensität der Strahlungsquelle stufenlos gesteuert werden kann und digital zur exakten Kontrolle der Belichtung der Druckplatte angezeigt wird. Somit sind die Ergebnisse stets reproduzierbar, auch bei einer Alterung der Strahlungsquelle oder Belichtungsintensitätsschwankungen, verursacht durch Temperaturschwankungen oder Netzstörungen. Weitere Vorteile des Nachbehandlungsgerätes bestehen darin, daß keine Störstrahlungen im Bereich der Belichtungs- und der Wärmestation auftreten können, daß unerwünschte UV-Anteile im Spektrum der Strahlungsquelle der Belichtungsstation durch spezielle Filterfolien bzw. Kantenfilter aus Glas oder PMMA ausgefiltert werden und daß für die Belichtung die Belichtungsöffnung in einem Bereich von 0,5 bis 20 mm einstellbar ist.

## Patentansprüche

1. Nachbehandlungsgerät für Druckplatten, die bildmäßig belichtet sind, mit einer Wärmestation und einer Belichtungsstation (2), die der Wärmestation (3) vorgeschaltet ist, dadurch gekennzeichnet, daß die Belichtungsstation (2) eine regelbare Strahlungsquelle (8) zur ganzflächigen Belichtung der Druckplatte (30) und eine Filterscheibe (9) aufweist, die an der Unterseite der Belichtungsstation (2) eine Belichtungsöffnung (13) abdeckt, und daß die Wärmestation (3) mit einer IR-Strahlungsquelle (18) in einem an drei Seiten mit einer Isolation (20, 21, 22) versehenen Gehäuse ausgerüstet ist, das nach unten auf einen Reflektortisch (7) hin offen ist, über den die Druckplatte (30) durch das Nachbehandlungsgerät (1) hindurchgeführt ist.

2. Nachbehandlungsgerät nach Anspruch 1, dadurch gekennzeichnet, daß die Strahlungsquelle (8) der Belichtungsstation (2) eine Leuchtstofflampe ist, deren Beleuchtungsstärke zwischen 30 % und 100 % der maximalen Beleuchtungsstärke mittels eines elektronischen Dimmers stufenlos regelbar ist.

3. Nachbehandlungsgerät nach Anspruch 2, dadurch gekennzeichnet, daß der Spektralanteil der Leuchtstofflampe im Wellenlängenbereich von 400 bis 700 nm liegt und daß 80% der emittierten Strahlung eine Wellenlänge größer als 500 nm haben.

4. Nachbehandlungsgerät nach Anspruch 1, dadurch gekennzeichnet, daß die Belichtungsöffnung (13) als Spalt ausgebildet ist, dessen Breite mittels eines Einstellmechanismus (14) von 0,5 bis 20 mm einstellbar ist.

5. Nachbehandlungsgerät nach Anspruch 1, dadurch gekennzeichnet, daß die Filterscheibe (9) aus einer Kunststoffscheibe (10) und einer auf diese Kunststoffscheibe aufgeklebten Filterfolie (11) besteht und daß die Filterfolie (11) für die Strahlung oberhalb des Spektralbereichs von 500 nm durchlässig und für Strahlung mit einer Wellenlänge kleiner/gleich 500 nm nahezu undurchlässig ist.

6. Nachbehandlungsgerät nach Anspruch 1, dadurch gekennzeichnet, daß die Filterscheibe (9) ein Kantenfilter aus speziell eingefärbtem Glas bzw. eingefärbtem Polymethylmethacrylat PMMA ist.

7. Nachbehandlungsgerät nach Anspruch 1, dadurch gekennzeichnet, daß im Gehäuseinneren der Belichtungsstation (2) ein Sensor (23) zur Messung der Beleuchtungsstärke der Strahlungsquelle (8) angeordnet ist und daß die Anzeige der Beleuchtungsstärke digital erfolgt.

8. Nachbehandlungsgerät nach Anspruch 1, dadurch gekennzeichnet, daß die IR-Strahlungsquelle (18) der Wärmestation (3) ein Infrarot-Dunkelstrahler aus Keramik ist, der Strahlung in einem Wellenlängenbereich weitab sowohl vom sichtbaren Wellenlängenbereich als auch vom Strahlungsempfindlichkeitsbereich der Druckplatten emittiert.

9. Nachbehandlungsgerät nach Anspruch 8, dadurch gekennzeichnet, daß die IR-Strahlungsquelle (18) Strahlung in einem Wellenlängenbereich von 1000 bis 10000 nm emittiert.

10. Nachbehandlungsgerät nach Anspruch 9, dadurch gekennzeichnet, daß die IR-Strahlungsquelle (18) in ihrer Strahlungsleistung so regelbar ist, daß die Druckplatte (30) auf eine Temperatur von 80 °C bis 120 °C erwärmbar ist.

11. Nachbehandlungsgerät nach Anspruch 1, dadurch gekennzeichnet, daß der Reflektortisch (7) als trogähnlicher Hohlkörper geformt ist, der auf der Höhe der Transportbahn (12) der Druckplatten (30) eine Bespannung (15) aufweist.

12. Nachbehandlungsgerät nach Anspruch 11, dadurch gekennzeichnet, daß die Bespannung (15) aus einem dünnen Metalldraht oder einem dünnen Kunststoffaden besteht, und V-förmig auf der Oberseite des Reflektortisches (7) aufgespannt ist.

13. Nachbehandlungsgerät nach Anspruch 10, dadurch gekennzeichnet, daß die Innenseite des Reflektortisches (7) mit einem wärmereflektierenden Metallblech ausgekleidet ist.

14. Nachbehandlungsgerät nach Anspruch 1, dadurch gekennzeichnet, daß für den Transport der Druckplatten (30) entlang einer Transportbahn (12) durch das Nachbehandlungsgerät ein Eingangs- und ein Ausgangstransportwalzenpaar (5, 6) vorhanden sind, die sich im Gehäuseinneren befinden und synchron von einer endlos umlaufenden Zahnradkette (29) angetrieben sind, die über Stirnzahnräder (25, 26, 27, 28) geführt ist, wobei die Stirnzahnräder auf den Wellen der Transportwalzen der beiden Transportwalzenpaare aufsitzen und eine der Transportwalzen des Eingangswalzenpaares (5) motorisch angetrieben ist.

## Claims

1. Post-treatment apparatus for printing plates which are exposed pictorially, with a heat station and an exposure station (2) which is accommodated in front of the heat station (3), characterised in that the exposure station (2) comprises an adjustable radiation source (8) for the whole-area exposure of the printing plate (30) and a filter plate (9) which covers an exposure opening (13) on the underside of the exposure station (2), and that the heat station (3) is equipped with an IR radiation source (18) in a casing provided on three sides with an insulation (20, 21, 22), which casing is open in a downward direction onto a reflector table (7) over which the printing plate (30) is passed through the post-treatment apparatus (1).

2. Post-treatment apparatus according to claim 1, characterised in that the radiation source (8) of the exposure station (2) is a fluorescent lamp whose luminous intensity is continuously adjustable between 30% and 100% of the maximum luminous intensity by means of an electronic dimmer.

3. Post-treatment apparatus according to claim 2, characterised in that the spectral component of the fluorescent lamp lies in the wave range of 400 to 700 nm and that 80% of the emitted radiation has a wavelength of more than 500 nm.

4. Post-treatment apparatus according to claim 1, characterised in that the exposure opening (13) is formed as a gap whose width is adjustable from 0.5 up to 20 nm by means of an adjustment mechanism (14).

5. Post-treatment apparatus according to claim 1, characterised in that the filter plate (9) consists of a plastics plate (10) and a filter foil (11) stuck to said plastics plate and that the filter foil (11) is permeable to the radiation above the spectral region of 500 nm and virtually impermeable to radiation with a wavelength less than/equal to 500 nm.

6. Post-treatment apparatus according to claim 1, characterised in that the filter plate (9) is a cutoff filter of specially tinted glass or tinted polymethyl methacrylate PMMA.

7. Post-treatment apparatus according to claim 1, characterised in that a sensor (23) for measuring the luminous intensity of the radiation source (8) is disposed on the inside of the casing of the exposure station (2) and that the display of the luminous intensity takes place digitally.

8. Post-treatment apparatus according to claim 1, characterised in that the IR radiation source (18) of the heat station (3) is an infrared dark radiator of ceramic material which emits radiation in a wave range far removed both from the visible wave range and from the radiosensitive range of the printing plates.

9. Post-treatment apparatus according to claim 8, characterised in that the IR radiation source (18) emits radiation in a wave range of 1 000 to 10 000 nm.

10. Post-treatment apparatus according to claim 9, characterised in that the IR radiation source (18) is adjustable in its radiant power in such a way that the printing plate (30) is heatable to a temperature of 80 °C to 120 °C.

11. Post-treatment apparatus according to claim 1, characterised in that the reflector table (7) is shaped as a hollow, trough-like object which has a covering (15) at the level of the conveyance track (12) of the printing plates (30).

12. Post-treatment apparatus according to claim 11, characterised in that the covering (15) consists of a thin metal wire or a thin plastics thread, and is stretched in a V shape on the top side of the reflector table (7).

13. Post-treatment apparatus according to claim 10, characterised in that the inside of the reflector table (7) is lined with a heat-reflecting metal plate.

14. Post-treatment apparatus according to claim 1, characterised in that there are provided for the conveyance of the printing plates (30) along a conveyance track (12) through the post-treatment apparatus a pair of inlet and a pair of outlet conveyance rollers (5, 6), which are located on the inside of the casing and are driven in synchrony by an endlessly circulating gear chain (29) which is guided by means of spur gears (25, 26, 27, 28), wherein the spur gears sit on the shafts of the conveyance rollers of the two pairs of conveyance rollers and one of the conveyance rollers of the pair of inlet rollers (5) is motor-driven.

## Revendications

1. Appareil (1) pour le post-traitement de plaques d'impression impressionnées de manière photographique, comportant une station d'échauffement (3) et une station d'exposition (2), qui est placée avant la station d'échauffement (3), caractérisé en ce que la station d'exposition (2) possède une source de rayonnement réglable (8) pour l'exposition de la surface entière de la plaque d'impression (30) et un disque de filtrage (9), qui recouvre une ouverture d'exposition (13) à la face inférieure de la station d'exposition (2), et en ce que la station d'échauffement (3) est équipée d'une source de rayonnement IR (18) dans un boîtier pourvu d'une isolation (20, 21, 22) sur trois côtés, lequel est ouvert vers le bas sur une table réflectrice (7) sur laquelle on guide la plaque d'impression (30) à travers l'appareil de post-traitement (1).

2. Appareil de post-traitement suivant la revendication 1, caractérisé en ce que la source de rayonnement (8) de la station d'exposition (2) est un tube fluorescent dont l'intensité lumineuse est réglable en continu entre 30% et 100% de l'intensité lumineuse maximale à l'aide d'un variateur électronique.

3. Appareil de post-traitement suivant la revendication 2, caractérisé en ce que la caractéristique spectrale du tube fluorescent se situe dans la plage de longueurs d'onde comprise entre 400 nm et 700 nm et en ce que 80% du rayonnement émis possède une longueur d'onde supérieure à 500 nm.

4. Appareil de post-traitement suivant la revendication 1, caractérisé en ce que l'ouverture d'exposition (13) a la forme d'une fente dont la largeur est réglable de 0,5 mm a 20 mm à l'aide d'un mécanisme de réglage (14).

5. Appareil de post-traitement suivant la revendication 1, caractérisé en ce que le disque de filtrage (9) se compose d'un disque de matière plastique (10) et d'un film de filtrage (11) collé sur ce disque de matière plastique et en ce que le film de filtrage (11) est transparent pour le rayonnement situé dans la zone spectrale au-dessus de 500 nm et pratiquement opaque au rayonnement de longueur d'onde inférieure ou égale à 500 nm.

6. Appareil de post-traitement suivant la revendication 1, caractérisé en ce que le disque de filtrage (9) est un filtre à arêtes en verre spécialement teinté ou en poly(méthacrylate de méthyle) PMMA teinté.

7. Appareil de post-traitement suivant la revendication 1, caractérisé en ce qu'un capteur (23) est disposé à l'intérieur du boîtier de la station d'exposition (2) pour la mesure de l'intensité lumineuse de la source de rayonnement (8) et en ce que l'affichage de l'intensité lumineuse se fait de façon numérique.

8. Appareil de post-traitement suivant la revendication 1, caractérisé en ce que la source de rayonnement IR (18) de la station d'échauffement, (3) est un radiateur obscur en céramique, qui émet un rayonnement dans une plage de longueurs d'onde fortement éloignée à la fois de la plage des longueurs d'onde visibles et de la plage de sensibilité au rayonnement des plaques d'impression.

9. Appareil de post-traitement Suivant la revendication 8, caractérisé en ce que la source de rayonnement IR (18) émet dans une plage de longueurs d'onde de 1000 nm à 10000 nm.

10. Appareil de post-traitement suivant la revendication 9, caractérisé en ce que la puissance de rayonnement de la source de rayonnement IR (18) est réglable de manière à pouvoir chauffer la plaque d'impression (30) à une température de 80°C à 120°C.

11. Appareil de post-traitement suivant la revendication 1, caractérisé en ce que la table réflectrice (7) a la forme d'un corps creux en forme d'auge qui présente un cordage tendu (15) à hauteur de la voie de transport (12) des plaques d'impression (30).

12. Appareil de post-traitement suivant la revendication 11, caractérisé en ce que le cordage tendu (15) est constitué d'un fin fil métallique ou d'un fin fil de matière plastique et est tendu en forme de V à la face supérieure de la table réflectrice (7).

13. Appareil de post-traitement suivant la revendication 10, caractérisé en ce que la face intérieure de la table réflectrice (7) est revêtue d'une tôle métallique réfléchissant la chaleur.

14. Appareil de post-traitement suivant la revendication 1, caractérisé en ce que, pour le transport des plaques d'impression (30) le long d'une voie de transport (12) à travers l'appareil de post-traitement, il existe une paire de rouleaux de transport d'entrée et une paire de rouleaux de transport de sortie (5, 6), lesquelles se trouvent à l'intérieur du boîtier et sont entraînées en synchronisme par une chaîne de roue dentée sans fin (29), qui est guidée par des roues dentées (25, 26, 27, 28), les roues dentées étant placées sur les arbres des rouleaux de transport des deux paires de rouleaux de transport et un des rouleaux de transport de la paire de rouleaux d'entrée (5) étant entraîné par un moteur.
